# EUROPÄISCHE PATENTSCHRIFT

(11) **EP 0 416 450 B1**
(45) Veröffentlichungstag und Bekanntmachung des Hinweises auf die Patenterteilung: **28.12.1994**
(21) Anmeldenummer: 90116530.8
(22) Anmeldetag: 29.08.1990
(51) Int. Cl.: H05K 7/14

(54) **Baugruppenträger**
Components support
Châssis

(30) Priorität: 08.09.1989 DE 3929971
(43) Veröffentlichungstag der Anmeldung: 13.03.1991
(73) Patentinhaber: Philips Broadcast Television Systems GmbH, 64347 Griesheim (DE)
(72) Erfinder: Sochor, Josef, Dipl.-Ing., D-6110 Dieburg (DE)
(74) Vertreter: von Laue, Hanns-Ulrich, Dipl.-Ing.

(56) Entgegenhaltungen:
- DE-A- 2 615 642
- GRUNDIG TECHNISCHE INFORMATIONEN, Bd. 28, Nr. 3, März 1981, FURTH, DE, Seiten 159-170;G. REISSLAND: 'GRUNDIG-FARBFERNSEHSTUDIO IN DER GESAMTSCHULE NUERNBERG LANGWASSER (GNL)'
- FUNKSCHAU, Bd. 46, Nr. 12, 7. Juni 1974,MüNCHEN DE,Seiten 467 - 468; DR. GOETZ CORINTH: 'EIN VIELSEITIGES MISCHPULT MIT INTEGRIERTEN SCHALTUNGEN'
- CHIP ZEITSCHRIFT FUER MIKROCOMPUTER-TECHNIK, Nr. 12, Dezember 1987, WüRZBURG DE, Seiten 142-146; 'COMPUTER ALS KLANGMIXER'

## Beschreibung

Die Erfindung geht aus von einem Baugruppenträger mit steckbaren Leiterplatten, die über Steckverbinder mit einer Rückwandleiterplatte in Eingriff stehen.

Aus der DE 26 15 642 A1 ist bereits ein Baugruppenträger mit Steckkarten und Leiterplatten als Querverbinder bekannt, bei welchem auf den Leiterplatten auf der Rückseite des Einschubs Steckverbinder für die einzelnen Steckkarten sowie Steckverbinder für die Verbindung zu einer Aufnahme angebracht sind. Die als Querverbinder dienenden Leiterplatten sind rückseitig nicht geschirmt.

Ferner ist aus der deutschen Zeitschrift "Rundfunktechnische Mitteilungen", Band 10 (1966), Heft 3, Seiten 110 bis 114, insbesondere Bild 12, einer auf der Rückseite eines Kassettenträgers aufgeschraubte Kabelanschlußplatte bekannt, welche neben den in Einschubrichtung der Kassetten angebrachten Buchsenleisten auch von der Außenseite zugängliche Kabelsteckverbinder aufweist. Die zur Aufnahme ankommender und abgehender Kabel externer Geräte vorgesehenen Kabelsteckverbinder sind mechanisch an einer metallischen Anschlußplatte befestigt. Die Querverdrahtung zwischen den Buchsenleisten sowie die Verdrahtung zu den rückseitigen Kabelsteckverbindern erfolgt auf der dem Kassettenträger zugewandten Seite der Anschlußplatte.

Weiterhin ist aus der deutschen Zeitschrift "Funkschau", Bd.46, Nr.12, 7. Juni 1974, München, ein Mischpult mit integrierten Schaltungen bekannt, bei welchem auf einer Anschlußplatte größere und kleine Buchsen, Umschalter und Klemmen in Form einer Schraubverbindung montiert sind. Die Anschlußplatte befindet sich auf der Rückseite des Mischpultgehäuses. Die Verdrahtung zu den auf der Anschlußplatte befindlichen Elemente ist als Kabelbaum ausgeführt.

Der vorliegenden Erfindung liegt die Aufgabe zugrunde, einen Baugruppenträger nach der eingangs genannten Art zu schaffen, der rückseitig geschirmt und der zudem bei der Verwendung von Kabelsteckverbindern unterschiedlicher Bautiefe einfach zu montieren ist.

Diese Aufgabe wird dadurch gelöst, daß beabstandet zur Rückwandleiterplatte eine Abdeckplatte aus elektrisch leitendem Material angeordnet ist, welche sich parallel zur Aufbaufläche von Kabelsteckverbindern unterschiedlicher Einbautiefe erstreckt, und welche hinsichtlich des Abstandes zur Rückwandleiterplatte an die unterschiedliche Einbautiefe der Kabelsteckverbinder angepaßt ist.

Der erfindungsgemäße Baugruppenträger weist den Vorteil auf, daß auch bei einer Verwendung von Kabelsteckern unterschiedlicher Bautiefe eine äußere Abschirmung der Rückwandleiterplatte möglich ist.

Durch die in den Unteransprüchen aufgeführten Maßnahmen sind vorteilhafte Weiterbildungen und Verbesserungen des im Patentanspruch 1 angegebenen Baugruppenträgers möglich.

Ein Ausführungsbeispiel der Erfindung ist in der Zeichnung dargestellt und in der nachfolgenden Beschreibung näher erläutert. Es zeigen:
- Fig. 1: eine perspektivische Darstellung des erfindungsgemäßen Baugruppenträgers und
- Fig. 2: eine Drauf- und Seitenansicht der Rückwandleiterplatte des Baugruppenträgers.

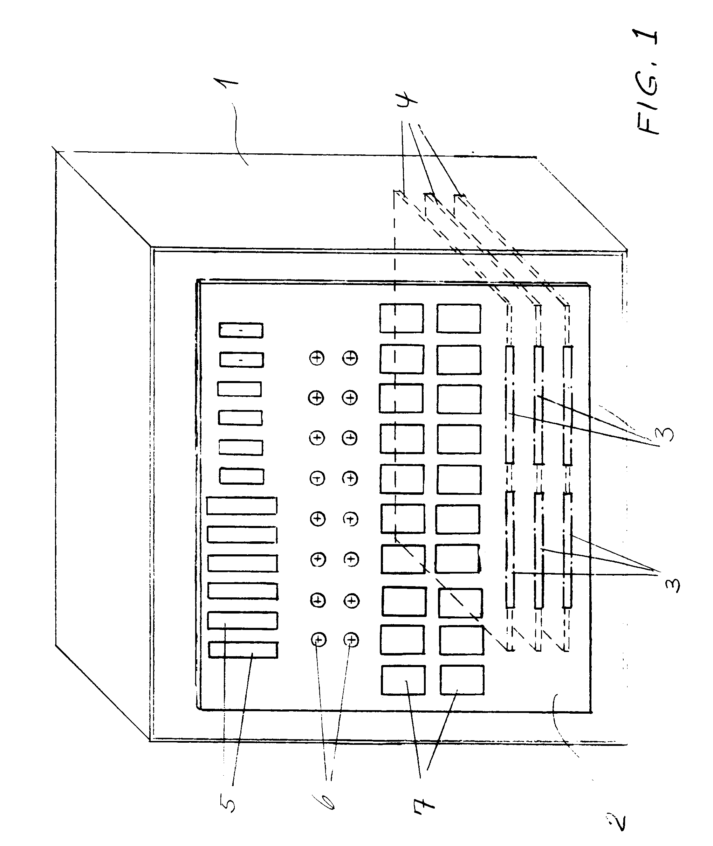

In der Fig. 1 bezeichnet 1 einen rahmenförmigen Baugruppenträger für ein Videomagnetbandgerät. An der Rückseite des rahmenförmigen Baugruppenträgers 1 ist eine Rückwandleiterplatte 2 angeordnet, auf der vor- und rückseitig verschiedene Steckverbinder befestigt sind. Eine Gruppe von strichpunktiert gezeichneten Buchsenleisten 3 dienen zum Anschluß von steckbaren Leiterplatten 4, die liegend über eine nicht dargestellte Einschubvorrichtung von vorn in den rahmenförmigen Baugruppenträger 1 geschoben werden. Die rückseitigen Schmalseiten der steckbaren Leiterplatten 4 sind mit Steckerleisten versehen, die in die entsprechenden Buchsenleisten 3 auf der Rückwandleiterplatte 2 eingreifen. Eine elektrische Verbindung zwischen den einzelnen Buchsenleisten 3 erfolgt über gedruckte Leiterbahnen der Rückwandleiterplatte 2.

Auf der den steckbaren Leiterplatten 4 abgewandten Rückseite der Rückwandleiterplatte 2 sind verschiedene Kabelsteckverbinder angeordnet, von denen mit 5 mehrpolige Subminiatur-Steckverbinder vom Typ SBM 383, mit 6 BNC-Buchsen für Koaxialkabel und mit 7 Tonbuchsen und -stecker für symmetrische Tonleitungen bezeichnet sind. Die zur externen Verkabelung vorgesehenen Kabelsteckverbinder 5, 6 und 7 sind elektrisch über Leiterbahnen der Rückwandleiterplatte 2 sowohl untereinander als auch mit den Buchsenleisten 3 verbunden. Da die Rückwandleiterplatte 2 zur elektrischen Verbindung einer Vielzahl von unterschiedlichen Signalen dient, besteht die Rückwandleiterplatte 2 aus mehreren Leiterbahnlagen. Einige dieser Leiterbahnlagen sind zur Übertragung hochfrequenter Signale vorgesehen und so ausgelegt, daß der Wellenwiderstand der gedruckten Leiterbahnen an den Wellenwiderstand der angeschlossenen Kabel angepaßt ist. Soll z.B. an den BNC-Buchsen 6 Koaxialkabel mit einer Impedanz von 75 Ohm angeschlossen werden, so sind die den entsprechenden BNC-Buchsen 6 zugeordneten Leiterbahnen in an sich bekannter Weise geometrisch so auszulegen, daß der Wellenwiderstand dem des angeschlossenen Koaxialkabels entspricht. Andere Lagen einer mehrlagigen Rückwandleiterplatte können beispielsweise der Betriebsspannungsversorgung oder der Übertragung von Steuersignaien vorbehalten sein.

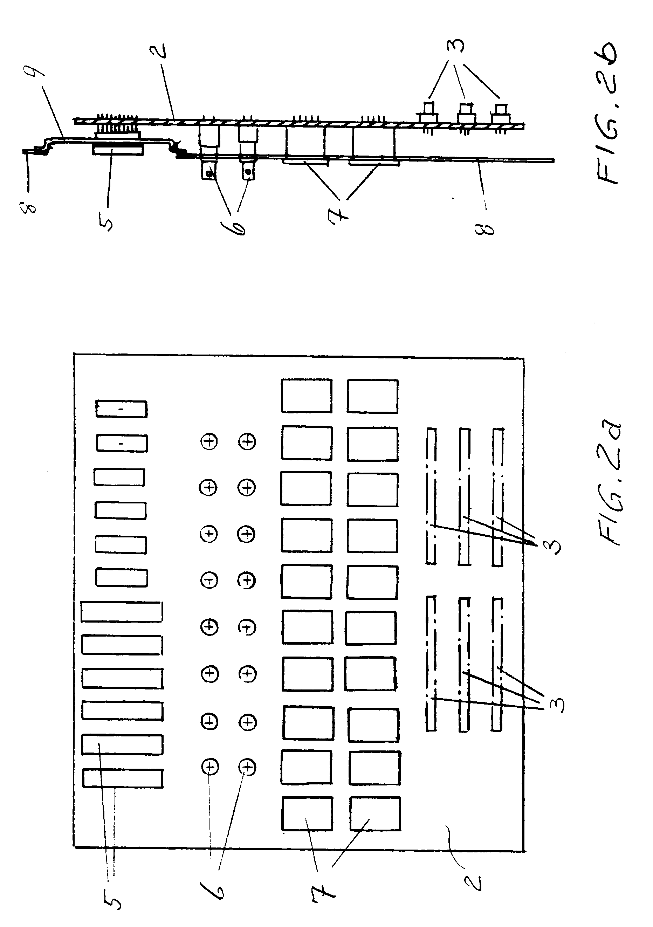

Die in der Fig. 1 perspektivisch dargestellte Rückwandleiterplatte 2 ist in der Fig. 2a mit geändertem Maßstab noch einmal als Draufsicht dargestellt. Gleiche Teile sind in den Figuren mit gleichen Bezugszeichen versehen. Eine Seitenansicht der Rückwandleiterplatte 2 zeigt die Fig. 2b. Dabei sind auf der linken Seite der Rückwandleiterplatte 2 die verschiedenen Kabelsteckverbinder 5, 6 und 7 dargestellt und auf der rechten Seite die Buchsenleisten 3 für die steckbaren Leiterplatten 4. Aus der Seitenansicht ist ersichtlich, daß die mehrpoligen Subminiatursteckverbinder 5 eine geringere Einbautiefe aufweisen als die BNC-Buchsen 6 oder die Tonbuchsen und -stecker 7. Zur Abdeckung der Rückwandleiterplatte 2 erstreckt sich parallel zur Aufbaufläche der Kabelsteckverbinder 5, 6 und 7 ein Abdeckblech 8 und 9, welches so geformt ist, daß den unterschiedlichen Einbautiefen der Kabelsteckverbinder 5, 6 und 7 Rechnung getragen wird. So ist beispielsweise das Abdeckblech im Bereich der mehrpoligen Subminiatursteckverbinder 5 in Richtung der Rückwandleiterplatte 2 gebogen, während es in den übrigen Bereichen der Anschlußebene der BNC-Buchsen 6 und den Tonbuchsen und -steckern 7 folgt.

Nach einer Ausgestaltung der vorliegenden Erfindung kann das Abdeckblech 8 auch Durchbrüche aufweisen, die einen Zugang zu den Kabelsteckverbindern geringerer Einbautiefe erlauben. Die fehlende Abdeckung für diese Kabelsteckverbinder erfolgt durch eine wannenförmig geformte Abdeckung 9, die niederohmig mit dem planen Abdeckblech 8 zu verbinden ist.

Da das Abdeckblech 8 und 9 an den Seitenteilen des rahmenförmigen Baugruppenträgers 1 befestigt wird, dient es nicht nur zum mechanischen Schutz der Rückwandleiterplatte 2, sondern auch zur Abschirmung gegenüber elektromagnetischer Strahlung, die von den im Inneren des Baugruppenträgers befindlichen Baugruppen ausgeht.

Die Montage der Rückwandleiterplatte 2 ist vorteilhafterweise so durchzuführen, daß zunächst die Rückseite der Rückwandleiterplatte 2 mit den Kabelsteckverbindern 5, 6 und 7 bestückt und zum Verlöten über eine Lötwelle geführt wird. Anschließend werden die Buchsenleisten 3 in Form einer Preßverbindung in vorbereitete Lochreihen auf der Lötseite der Rückwandleiterplatte 2 gedrückt und so der elektrische Kontakt zu den Leiterbahnen der Rückwandleiterplatte 2 hergestellt. Abschließend erfolgt die Montage der Abdeckbleche 8 und 9.

## Patentansprüche

1. Baugruppenträger (1) mit
mehreren steckbaren Leiterplatten (4), welche an ihrer rückseitigen Schmalseite Steckverbinder aufweisen,
einer Einschubvorrichtung zur Führung der steckbaren Leiterplatten (4),
einer der Einschuböffnung gegenüberliegenden Rückwandleiterplatte (2), auf welcher der den steckbaren Leiterplatten (4) zugewandten Seite Steckverbinder (3) zur Verbindung der steckbaren Leiterplatten (4) angeordnet sind und auf welcher der den steckbaren Leiterplatten (4) abgewandten Seite Kabelsteckverbinder (5, 6, 7) zur Verbindung des Baugruppenträgers (1) mit örtlich abgesetzten Geräten angeordnet sind,
**dadurch gekennzeichnet**, daß beabstandet zur Rückwandleiterplatte (2) eine Abdeckplatte (8,9) aus elektrisch leitendem Material angeordnet ist, welche sich parallel zur Aufbaufläche von Kabelsteckverbindern (5, 6, 7) unterschiedlicher Einbautiefe erstreckt, und welche hinsichtlich des Abstandes zur Rückwandleiterplatte an die unterschiedliche Einbautiefe der Kabelsteckverbinder angepaßt ist.

2. Baugruppenträger nach Anspruch 1, **dadurch gekennzeichnet**, daß die Abdeckplatte (8) Durchbrüche zum Zugang zu Kabelsteckverbindern (5) geringer Einbautiefe aufweist, die durch eine wannenförmig geformte Abdeckung (9) abgedeckt sind, die niederohmig mit der Abdeckplatte (8) verbunden ist.

3. Baugruppenträger nach Anspruch 1 und 2, **dadurch gekennzeichnet**, daß die Abdeckplatte (8,9) an Seitenteilen des Baugruppenträgers (1) befestigt ist.

4. Baugruppenträger nach Anspruch 1, **dadurch gekennzeichnet**, daß von den Kabelsteckverbindern (5, 6, 7) unterschiedlicher Einbautiefe Gruppen mit gleicher Einbautiefe zusammengefaßt und durch eine Lötverbindung auf der Rückwandleiterplatte (1) befestigt sind.

5. Baugruppenträger nach Anspruch 4, **gekennzeichnet durch** eine mehrlagige Rückwandleiterplatte (2), bei welcher Leiterbahnen einzelner Leiterfolien so ausgelegt sind, daß der Wellenwiderstand der Leiterbahnen mit dem Wellenwiderstand zugeordneter Kabelsteckverbinder (6) und/oder mit dem Wellenwiderstand der über zugeordnete Kabelsteckverbinder (6) angeschlossenen Kabel übereinstimmt.

## Claims

1. A chassis (1) comprising
a plurality of plug-in p.c. boards (4) having connectors at their rearward edges,
a guide means for guiding the plug-in p.c. boards (4),
a backpanel p.c. board (2) which is disposed opposite the insertion opening and which on its side which faces the plug-in p.c. boards (4) carries receptacles (3) for receiving the plug-in p.c. boards (4) and on its side which is remote from the plug-in p.c. boards (4) carries cable connectors (5, 6, 7) for the connection of the chassis (1) to remote apparatuses,
**characterised in that** a cover plate (8, 9) of an electrically conductive material is arranged to be spaced from the backpanel p.c. board (2) and extends parallel to the mounting surface of cable connectors (5, 6, 7) having different mounting depths, the distance of said cover plate from the backpanel p.c. board being adapted to the different mounting depths of the cable connectors.

2. A chassis as claimed in Claim 1, **characterised in that** the cover plate (8) has openings for access to cable connectors (5) having smaller mounting depths, which connectors are covered by a trough-shaped cap (9) having a low-impedance connection with the cover (8).

3. A chassis as claimed in Claims 1 and 2, **characterised in that** the cover plate (8, 9) is secured to side portions of the chassis (1).

4. A chassis as claimed in Claim 1, **characterised in that** of the cable connectors (5, 6, 7) having different mounting depths groups having an equal mounting depth are combined and connected to the backpanel p.c. board (1) by a soldered joint.

5. A chassis as claimed in Claim 4, **characterised by** a multi-layer backpanel p.c. board (2) in which the conductors of the individual layers are dimensioned in such a manner that the characteristic impedance of the conductors corresponds to the characteristic impedance of the associated cable connectors (6) and/or the characteristic impedance of the cables connected via associated cable connectors (6).

## Revendications

1. Support de composants (1) comprenant
plusieurs plaques de circuits imprimés enfichables (4) dont le côté étroit arrière présente plusieurs connecteurs à fiches,
un dispositif d'insertion pour le guidage des plaques de circuits imprimés enfichables (4),
une plaque de circuits imprimés de paroi arrière (2) qui est située en face de l'ouverture d'insertion et sur la face située vis-à-vis de la plaque de circuits imprimés enfichable (4) de laquelle sont disposés des connecteurs à fiches (3) pour la connexion des plaques de circuits imprimés enfichables (4) et sur la face opposée aux plaques de circuits imprimés enfichables (4) de laquelle sont disposés des connecteurs à fiches de câble (5, 6, 7) pour les connexions du support de composants (1) avec des appareils disposés à d'autres endroits, caractérisé en ce qu'à une certaine distance de la plaque de circuits imprimés de paroi arrière (2) est disposée une plaque de recouvrement (8, 9) en matériau électroconducteur qui s'étend parallèlement à la surface de montage de connecteurs à fiches de câble (5, 6, 7) de profondeur d'incorporation différente et qui est adaptée, en ce qui concerne la distance, à la plaque de circuits imprimés de paroi arrière et la profondeur d'incorporation différente des connecteurs à fiches de câble.

2. Support de composants selon la revendication 1, caractérisé en ce que la plaque de recouvrement (8) présente des ouvertures donnant accès aux connecteurs à fiches de câble (5) de faible profondeur d'incorporation qui sont recouvertes par un recouvrement en forme de cuvette (9) qui est relié à faible résistance à la plaque de recouvrement (8).

3. Support de composants selon les revendications 1 et 2, caractérisé en ce que la plaque de recouvrement (8, 9) est fixée aux parties latérales du support de composant (1).

4. Support de composants selon la revendication 1, caractérisé en ce que parmi les connecteurs à fiches de câble (5, 6, 7) de profondeur d'incorporation différente les groupes présentant une profondeur d'incorporation égale sont réunis et fixés par soudage sur les plaques de circuits imprimés de paroi arrière (1).

5. Support de composants selon la revendication 4, caractérisé par une plaque de circuits imprimés de paroi arrière multicouche (2) dans laquelle des pistes conductrices de feuilles conductrices individuelles sont dimensionnées de façon que l'impédance caractéristique des pistes conductrices corresponde à l'impédance caractéristique des connecteurs à fiches de câble correspondants (6) et/ou à l'impédance caractéristique du câble connecté par l'intermédiaire de connecteurs à fiches de câble (6).
